## (19) Europäisches Patentamt
## European Patent Office
## Office européen des brevets

(11) **EP 1 271 162 B1**

(12) **EUROPEAN PATENT SPECIFICATION**

(45) Date of publication and mention
of the grant of the patent:
**26.10.2005 Bulletin 2005/43**

(51) Int Cl.⁷: $G01R\ 31/00$, $G01R\ 31/3185$

(21) Application number: **02254231.0**

(22) Date of filing: **18.06.2002**

(54) **Test system**

Testsystem

Système de test

(84) Designated Contracting States:
**AT BE CH CY DE DK ES FI FR GB GR IE IT LI LU
MC NL PT SE TR**

(30) Priority: **20.06.2001 US 299175 P**

(43) Date of publication of application:
**02.01.2003 Bulletin 2003/01**

(73) Proprietor: **Broadcom Corporation**
**Irvine, CA 92618-3616 (US)**

(72) Inventor: **Evans, Richard J.**
**Clifton, Bristol BS8 4EU (GB)**

(74) Representative: **Jehle, Volker Armin et al**
**Patentanwälte**
**Bosch, Graf von Stosch, Jehle,**
**Flüggenstrasse 13**
**80639 München (DE)**

(56) References cited:
**US-A- 5 519 715       US-A- 5 875 153**
**US-A- 5 909 451       US-A- 6 163 865**

- **PATENT ABSTRACTS OF JAPAN vol. 1998, no.
07, 31 March 1998 (1998-03-31) -& JP 08 201481
A (INTERNATL BUSINESS MACH CORP
&LT;IBM&GT;), 9 August 1996 (1996-08-09)**

**Description**

FIELD OF THE INVENTION

The present invention relates to apparatus and a method of testing digital logic circuits, in particular faults in circuit operation during operational transitions in the circuit.

BACKGROUND OF THE INVENTION

Commonly used scan test methodology generally tests for transition faults using two or more capture cycles between shifts in order to test logic performance in addition to absolute function. The clock tick in the first capture phase disturbs the state of the logic (causing a transition) and a second capture cycle is used to capture the result. Transition fault testing thus makes it possible to carry out shifting of the scan chains at low speed and then to provide two fast clock pulses for the capture cycle, thereby detecting many more timing related defects than in a conventional scan.

More specifically, during scan testing all flip-flops in a circuit can be connected into one or more shift registers (the shift phase of the test), so that they can be preloaded with values by external test equipment (ATE). During the capture phase of the test these values are propagated through the circuit. The resulting values are captured back into the flip-flops before being shifted off chip (using the shift phase again) for comparison with expected values by the ATE. Chips are "failed" if defects introduced during manufacture cause the actual data to differ from that expected.

Scan testing is usually carried out at slow speed, so is not a good test for defects which affect the performance of the logic rather than the absolute function. To address this, transition fault testing, extends the scan test method so that there are two (or more) capture cycles between shifts. As before, the shift phase is used to set all flip-flops (and therefore all combinatorial nodes) to particular values. The clock tick in the first capture phase is used to disturb the state of the logic (causing a transition) and the second capture cycle is used to capture the result.

The key difference here is that the time between the two active clock edges in the capture cycles determines the timing accuracy of the test - we are now independent of any slow global signal timing, such as the "scan_enable" (scan_en) signal used to switch between shift and capture phases, and the usually non-optimised path through the shift registers. So it is possible to carry out the shifting of the scan chains at low speed and then to provide two fast clock pulses for the capture cycle, detecting many more timing related defects than conventional scan.

This is an established technique and tools exist to create test patterns for application using this methodology. However, there are now integrated circuits (ICs) which are clocked at hundreds of MHz and it is difficult to inject pulses so close together (say within a couple of ns of each other) onto an IC from external test equipment, both from a point of view of the edge placement accuracy of the ATE and also signal integrity issues in getting the pulses through the IC pads and distributed over the core of the IC.

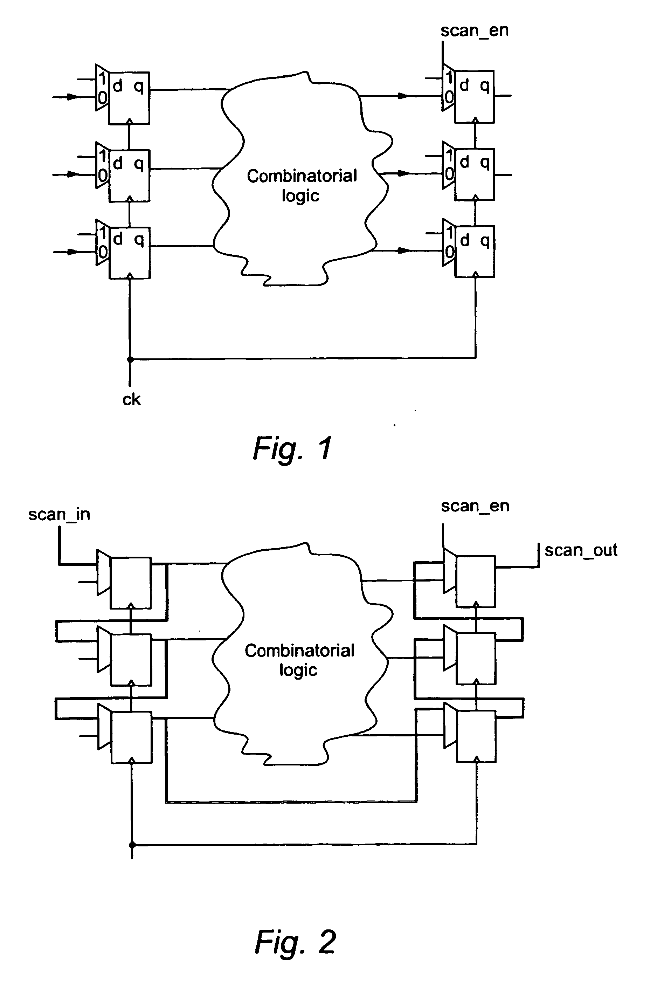

A specific example of a conventional capture scan is shown in Figure 1, in which the thick lines depict the capturing of data by the flip-flops when the scan_en signal is set low (to 0). Figure 2 shows how the flip-flops can be used as a shift register when scan_en is set high (to 1) allowing data to be loaded into the flip-flops from the scan_in input and shifting out any values loaded into the flip-flops during the capture cycle for observation at scan out. The state of the combinational logic is not important during shifting as long as it is electrically safe.

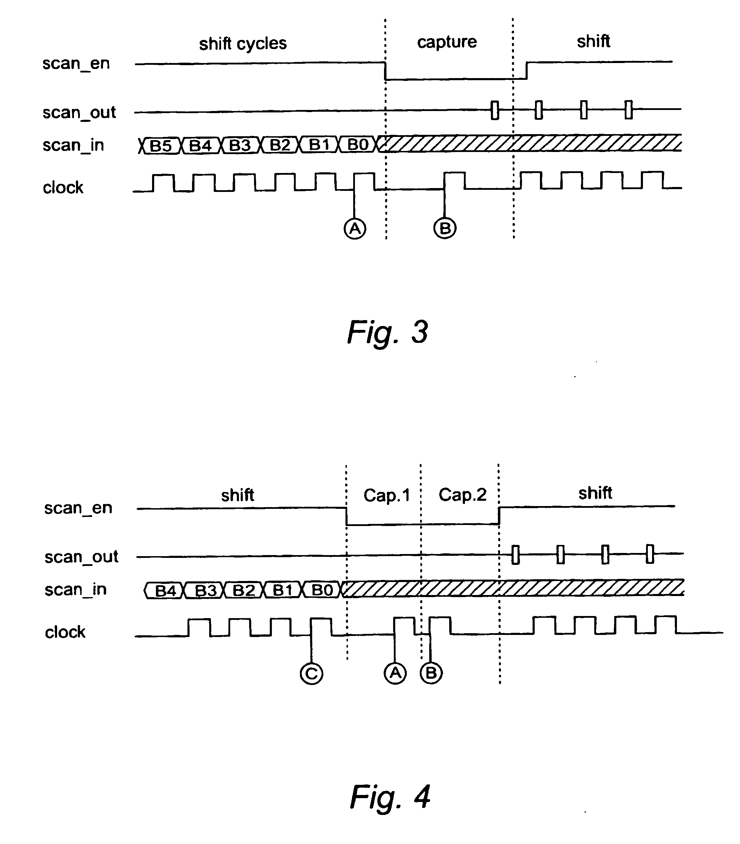

Figure 3 shows how a transition test can be carried out during a normal scan operation. At point A the rising edge of the clock causes a transition which can be observed in a flip-flop at point B. The quality of the test is determined by how close edges A and B can be brought together. Usually the time between the edges A and B is large, in part because it is difficult to get high speed clocks in an integrated circuit and in part because the heavily loaded scan_en signal must transition between A and B.

Figure 4 shows a known attempt to improve upon the situation in Figure 3 by using two capture cycles. The flip-flops are loaded with an initial state on rising edge C. Clock edge A now disturbs this state and causes a transition which can be observed in a flip-flop at point B. As there is no transition on scan_en between A and B it is possible to bring the edges closer together. However, the edges A and B still cannot be brought close enough, that is to the operating speed in the circuit easily (at 300 MHz, for example, $T_B$-$T_A$ would have to be less than 3.3 ns). It has not been possible o achieve this with a low cost test device and even with an expensive device it has not been possible to reach these speeds.

JP-A-08201481 describes a PLL circuit converting a 33 MHz low-frequency clock which is inputted to a 100 MHz high-frequency clock signal and supplies it to an additional clock circuit. The additional clock circuit starts generating a clock (a delay pulse comprising two pulse waves) at the same interval as the high-frequency clock frequency generated internally by the PLL circuit. An order circuit block of scan path design successively outputs data every time it receives clocks by inputting data, and forms a shift register on testing. In a delay pulse test mode, the clock circuit distributes generated clocks to each latch circuit, thus executing the delay pulse test of the block in terms of AC. Thus, a delay pulse test at a high frequency equivalent to an internal clock is enabled by generating a high-frequency clock signal based on an input clock and generating a delay pulse with the same delay width as the period thereof.

US-A-5,519,715 describes a method for loading a compiled test program into a microprocessor's internal caches and then controlling the execution of that program. Initially, the microprocessor's internal clock is disabled. Then for each memory location specified in the compiled program, the memory content associated with that location is loaded into the appropriate microprocessor cache. This is accomplished in two primary steps. First, the memory content is shifted into positions on the pins of the microprocessor by a boundary scan shift operation via an IEEE 1149.1 interface. Second, after the pins have the appropriate bit values for the current memory content, an external clock supplies the microprocessor with clock cycles that are then used by the microprocessor to control the loading of data/ instructions from the pins into the appropriate data or instruction cache. The process of loading the pins with data via boundary scan, and then shifting data into appropriate caches is repeated for each memory content of the compiled program until all instructions in the program have been loaded into the appropriate caches. Thereafter, the microprocessor is forced into normal execution mode by resetting the microprocessor to re-enable its internal clock. Finally, the test program is executed in a manner that allows a user to interact with the microprocessor during execution.

## SUMMARY OF THE INVENTION

The object of present invention is to provide improved testing of logical circuits. This object is solved by a method having the features according to claim 1 and a system having the features according to claim 5.

According to an embodiment, there is provided a method of testing a logic circuit which is driven by high frequency oscillating means and an external clock, which external clock during normal operation is used to time control of the operation of the circuit, the method including the step of disabling the external clock, synchronising testing means with the internal oscillating means, performing testing on the circuit while the external clock is disabled and re-enabling the external clock following testing.

In the preferred embodiment, the oscillation means which is used is a phase locked loop within the logic circuit.

Advantageously, the method includes the step of determining the length of time during which the external clock is disabled. This may be for two or more clock cycles of the internal clock.

The method preferably tests operation of the circuit during transitions.

According to another embodiment, there is provided a system for testing a logic circuit which is driven by high frequency oscillating means and an external clock, which external clock during normal operation is used to time control of the operation of the circuit; the system including a clock controller operable to disable the external clock, to synchronise testing means with the internal oscillating means, and to re-enable the external clock following testing on the circuit.

It will be apparent that the circuit could be any logic circuit including a microprocessor.

In the preferred embodiment, the test clock is synchronised with the PLL internal to the circuit. For transition testing, a synchronising circuit disables the propagation of the external clock prior to the capture phase. During the capture phase a predetermined number of high speed PLL pulses are emitted and the synchroniser then switches back to the external clock to shift the captured data off-chip.

The preferred embodiments address the difficulties with the conventional test methodology by synchronising the test clock with the phase locked loop (PLL) internal to the IC, in the preferred embodiment this being achieved as follows:

a) during scan chain shifting the internal clock is taken from a conventionally supplied external clock;
b) prior to the capture cycles a synchronising circuit disables propagation of the external clock and prepares to switch to using the internal PLL;
c) during the capture phase a programmable number of high speed PLL pulses are emitted (in some cases more than 2 capture cycles are required to detect particular faults) before the synchroniser prepares to switch back to the external clock;
d) the data in the flip-flops is now shifted off chip using the externally supplied clock (for synchronising with the external ATE).

The advantages of the preferred embodiment are the following:

a) switching between external and PLL clocks is always clean, so that there are no "runt" pulses which would invalidate the test;
b) there are no critical timings of external signals, so that it is possible to run very high speed transition fault tests (say 500 MHz) using low cost ATE capable only of modest speed (50 MHz) and pin edge placement accuracy;
c) the synchroniser circuit allows for a pre-programmed number of PLL pulses to be emitted (in Santorini the number is 1 <N<5, but in principle higher numbers could be used) to test faults which require several capture cycles to produce and capture the relevant transition.

DESCRIPTION OF THE DRAWINGS

An embodiment of the present invention is described below, by way of example only, with reference to the accompanying drawings, in which:

Figure 1 is a schematic diagram of a test circuit providing conventional scan:capture operation;

Figure 2 is a schematic diagram of a test circuit providing a conventional scan:shift cycle;

Figure 3 is a timing diagram showing a transition test performed by the circuit of Figure 2;

Figure 4 is a timing diagram of a transition test using two capture cycles;

Figure 5 is a schematic diagram of an embodiment of test circuit according to the present invention;

Figure 6 is a timing diagram of a transition test using the test circuit of Figure 5;

Figure 7 is a block diagram of an example of clock controller;

Figures 8a and 8b show the form of a PLL control register used in the controller of Figure 7;

Figure 9 shows the form of another register used in the controller of Figure 7;

Figure 10 is a simplified schematic diagram of an example of reset logic for the controller of Figure 7;

Figure 11 is a block diagram of an example of reset status register for the reset logic of Figure 10;

Figure 12 is a block diagram of an example of a clock switching circuit for the controller of Figure 7;

Figure 13 is a block diagram of a circuit for generating gck and gck/2 clock pulses for the controller of Figure 7;

Figure 14 shows signals used for a Test Control Block (TCB) clock controller interface for the controller of Figure 7;

Figure 15 shows the clock switching circuit of Figure 12 to which the control signals of Figure 14 have been applied; and

Figure 16 is a schematic diagram of a pulse stream gate for the controller of Figure 7.

DESCRIPTION OF THE PREFERRED EMBODIMENT

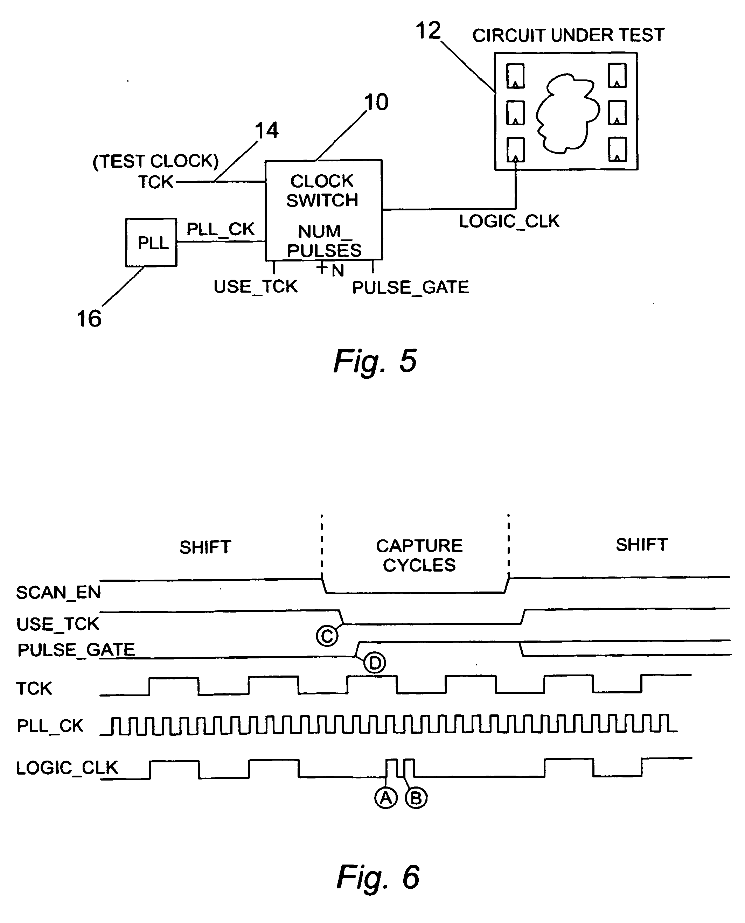

Referring to Figure 5, the preferred embodiment of test assembly includes a clock switch 10 which is interposed in the clock line between the logic circuit 12, that is the circuit to be tested, and the conventional externally supplied test clock 14 and the free-running internal PLL clock 16. The output of the clock switch 10 is the logic_clk line, which is the clock signal actually seen by the internal logic circuit under test.
The clock switch includes three control inputs shown as use_tck, pulse_gate and num_pulses, the functions of which are described below. These signals are externally controlled by a test controller (not shown) of an ATE. The scan_en signal is generally held high so as to perform scan shifting and is low for capture cycles.
When scan_en is pulled low (to go from shift to capture cycle), the signal is allowed to stabilise over the whole circuit before allowing any pulses through. Hence pulse_gate is kept low until this has been achieved, making the system independent of ATE edge placement accuracy for the scan_en signal. The control of the clock switch 10 is such as to ensure that all switching transitions are clean, without any glitches or runt pulses, and that none of the control signals is timing critical.
When use_tck is high, the clock switch 10 couples the test clock 14 to the circuit 12 to be tested, as with conventional shift cycles. However, when the input pulse_gate is set high, a pre-programmed number of pulses from the PLL clock 16 is coupled through to the circuit under test in place of the test clock. In the example shown, two pulses are allowed to pass, although this number can be chosen as desired by the user.

With reference to the timing diagram of Figure 6, the enhanced transition test allowed with the clock switch 10 is as follows.

During shifts the test clock TCK is gated through the clock switch to form the logic_clk signal sent to the circuit 10 under test. In the capture cycle when the signal scan_en goes low, the use_tck input to the clock switch 10 goes low (at time C), effectively stopping all the test clock pulses passing through to the circuit 10. When the pulse_gate input goes high (at time D), after a number of PLL clock cycles (depending upon when in the PLL_ck cycle pulse_gate was asserted) the clock switch 10 switches to the PLL clock 16 to pass to line logic_clk and thus to the circuit 12 the pre-programmed number PLL_clk pulses (in this example two pulses).

No clock pulses from the test clock 14 are passed through the clock switch 10 until the use_tck signal goes high again. When this occurs, the test clock TCK signal is again gated through the switch 10 to synchronise scan_in/out data to the external ATE as normal.

Thus, during the period in which the PLL_ck pulses are gated through the switch 10 the clock frequency to which the ATE is synchronised is at a much higher frequency than can be provided by the conventional test clock 14. In particular, the time $T_A$-$T_B$ is now dependant solely on the PLL clock. The time $T_A$-$T_D$ is not at all important to the test; similarly transitions on scan_en and use_tck are not critical.

It will be apparent to the skilled person that the signal pulse_gate can either be left high or driven low after passage of the predetermined number of PLL clock signals through the switch 10. Its state does not matter because no more PLL pulses will be driven, that is only the rising edge of pulse_gate is significant, so again the system is not dependent on ATE edge placement accuracy.

The clock controller used in this example is the controller known as the Santorini clock controller, which provides the following services during normal operation:

- register based programming of the PLL parameters;
- glitch free switching between crystal and PLL clock sources;
- reset control following power-on, pin or watchdog initiated resets.

Additionally the Santorini clock controller interacts with the Test Control Block (TCB) to implement several test features, including:

- JTAG selection of TCK or PLL source for BIST and other test modes
- JTAG programming of PLL parameters
- clean switch between PLL and TCK for CoreDump operation
- clean gating of variable length PLL pulse trains for transition fault testing
- a test counter for test of the PLL itself in production

The clock and reset controller module is responsible for: sequencing internal reset operations; programming the PLL to select the operating frequency; and selecting and cleanly switching (without glitches) between clock sources for distribution to the clock tree.

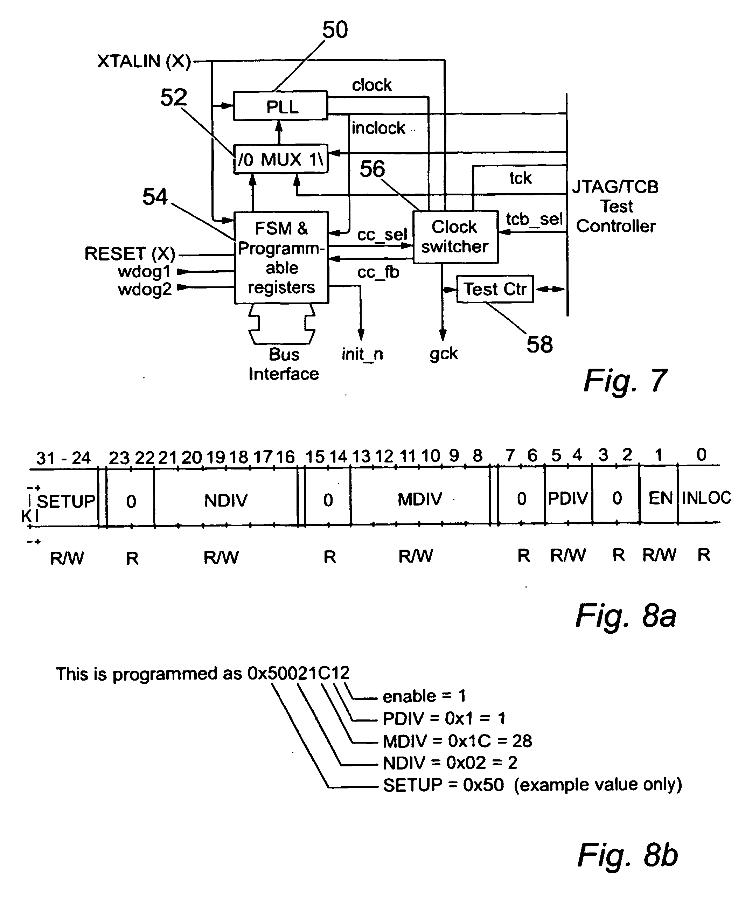

A block diagram of the Santorini clock controller is shown in Figure 7. The controller has a built-in phase locked loop (PLL) clock 50, the output of which is derived from the clock input based on the static signals supplied to the control portion of the PLL via multiplexer (MUX) block 52.

The multiplexer block 52 is a simple combinatorial multiplexer with the test control block choosing whether to take the static control values from the clock controller registers (the default) or from one of the JTAG registers. Giving control of the multiplexer 52 to the test control block allows the clock controller to be scan tested like the rest of the integrated circuit (IC). In normal operation the test control block is in an inactive state so that the clock controller effectively controls the PLL 50 by default.

The FSM & programmable register block 54 provides the register based interface required to the bus. This allows the core to program up the PLL parameters and to select between different clock sources This block 54 also deals with the reset sequencing on start-up or when triggered by one of the watchdog inputs. Clean switching from one clock to another is handled by the FSM block 54 in conjunction with clock switcher 56.

The clock switcher 56 contains the logic which can select any one of the xtal_in, PLL or (in test mode only) TCK clocks as the source of the global core clock gck. The switching takes place while both the current clock and the requested clock are running and must be accomplished cleanly with no glitches. Retiming logic in the switcher 56 ensures that the original clock is stopped while it is low and that the new clock is started while it is also low. Again, the test control block has priority in selection of clock source over the clock controller FSM 54.

Finally, the test counter 58 is a simple resettable ripple counter (non-scannable) which can count at the highest rate of the PLL 50. This is used only to test the operation of the PLL 50 and is controlled and read back through the JTAG port.

The registers described below will exist physically in the register block accessible over Santorini's TDM bus. They are then read/writable by the host port and the processor or processors coupled thereto.

The clock controller provides just two registers:

PLL_CONFIG_RED - for programming and enabling of the PLL 50; and
PLL_STATUS_RED - for selection of either the crystal or PLL frequency for distribution to the core. This register also provides the reset status.

Referring to Figures 8a and 8b, the PLL_CONFIG_RED or PLL Parameter register is a 32-bit register. All the bits in this register are set to zero when the circuit is reset. The allocation of bits in this register is such that the various divider values are all byte aligned for convenience. All bits in the register are readable by the core. However only the divider and set-up values and the enable bit are writable; all other bits return a constant value of zero except for the INLOCK bit which is always provided directly from the PLL.

The cut-out frequency of the PLL 50 is related to the input frequency and divider stages by the following equation:

$$F_{out} = F_{in} * (2M/(N*(2^P)))$$

So, for example, to program a value of 495 MHz using a 35.329 MHz crystal the following the divider values could be used: M = 28; N = 2 and P = 1. This is programmed as shown in Figure 8b.

Note that this register is only accessible a byte at a time from the host port. So, when programming via the host port the enable bit (bit1) should be cleared before programming the upper bytes. This prevents the PLL 50 being left to operate with potentially illegal combinations of values in the upper bytes. Once all values in the upper bytes have been programmed to legal values, the PDIV bits and the enable bit can be set simultaneously to start the PLL 50.

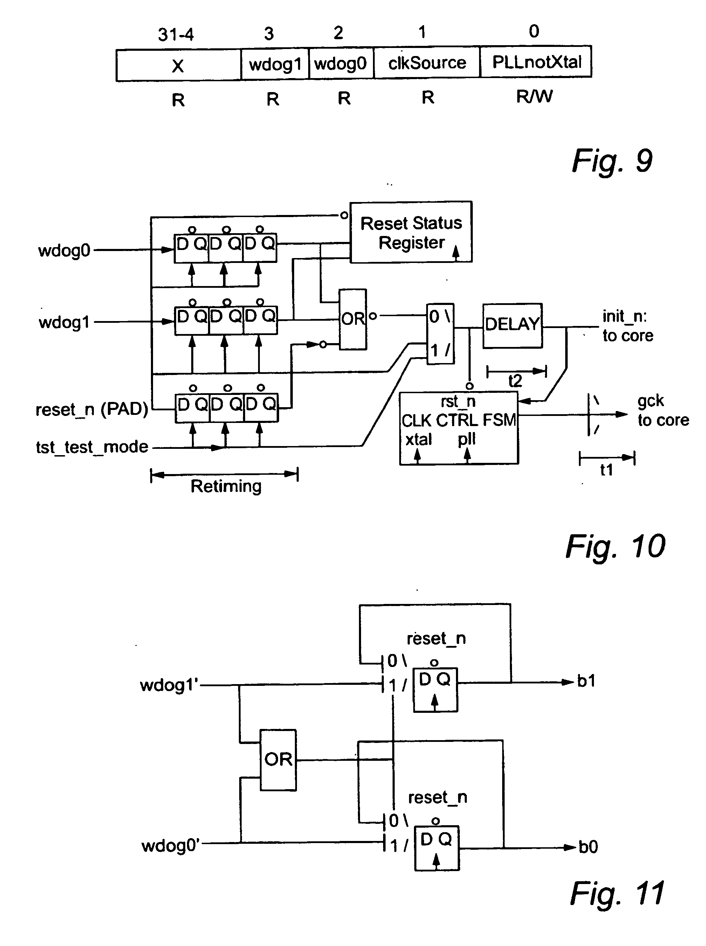

The PLL_STATUS_RED register can be seen in Figure 9. This register contains only a single read/writable bit, PLLnotXtal, and three read only bits clkSource, wdog0 and wdog1. When PLLnotXtal is '1', the PLL 50 is selected to drive the main clock tree; when PLLnotXtal is '0' the clock tree is driven directly by a clock signal generated from the crystal source. When the IC is powered up the PLLnotXtal bit is set to zero to choose the crystal clock source.

Writing a value into the PLLnotXtal bit is a request to change the clock source. This change will be carried out by the clock controller but re-synchronising to the new clock source requires a number of cycles of xtal and the target clock. The bit in the clkSource register indicates which clock source is actually selected (1 for the PLL, 0 for xtal) and will effectively follow the value in PLLnotXtal after a short delay.

The two wdog bits return the status of the watchdog triggers when the IC was last reset according to the following table:

| Wdog1 | wdog0 | Last reset was triggered by... |
|---|---|---|
| 0 | 0 | ... power on/external reset pin |
| 0 | 1 | ... watchdog timer 0 |
| 1 | 0 | ... watchdog timer 1 |
| 1 | 1 | ... both watchdogs firing simultaneously (unlikely) |

All other bits in this register are undefined; that is the upper bits should always be masked off when reading this register.

When the circuit is powered up, the clock Xtal is selected and provided to the circuit core. In this example, this is a 35.328 MHz crystal. To switch to PLL operation, the PLL_CONFIG_REG register is programmed with the required PLL parameters and the PLL 50 enabled. The INLOCK bit is then set before setting the PLLnotXtal bit in the PLL_STATUS_RED register. Setting the PLLnotXtal bit before the PLL has achieved lock could have unpredictable results.

Once the PLL 50 has been programmed and chosen as the core clock source, it should not be reprogrammed 'on the fly' to adjust the frequency. Doing so could cause glitches in the clock output to the core and lead to unpredictable circuit operation. To ensure that this does not occur, the PLL_CONFIG_RED register is locked (not writable) whenever the PLLnotXtal bit in register PLL_STATUS_RED is set.

It is possible to reprogram the PLL 50 by first switching back to the crystal clock source by writing 'zero' into the PLLnotXtal bit of PLL_STATUS_REG. Now the PLL can be reprogrammed normally.

Resets can be initiated either from the physical reset pin or by one of the two watchdog input signals from the core. All reset sources are preferably logically OR'ed together so as to behave identically. Duration of the reset pulse is controlled internally synchronously to the xtal in clock (mainly to ensure that watchdog reset pulses are not truncated by the watchdog itself resetting).

The preferred reset sequence in the clock controller follows the three phases.

Phase 1 occurs when reset is asserted externally, in which: the clock controller is asynchronously reset immediately, stopping transmission of any further clock pulses to the core; and the global initialisation signal (init_n) is asserted after a sufficient delay to allow all clocks to the core to have stopped.

Phase 2 occurs when init_n is asserted internally, such that: no clocks are supplied to the core; and all tri-state buses and one-hot multiplexers are driven to a safe, non-contentious state by using a test override signal.

Phase 3 occurs when reset is deasserted externally, in which case: the init_n signal is deasserted immediately (while all clocks are still low); the reset on the clock controller is deasserted on a subsequent rising edge of xtal_in; the clock controller chooses xtal_in by default as the system clock and begins supplying this clock to the main clock tree, making the switch while xtal_in is low; and the circuit resumes normal operation as soon as clocks begin to arrive, completing any logical reset/boot sequence as required.

A simplified schematic diagram of an example of reset logic is shown in Figure 10.

In this example, the watchdog inputs are shown with positive polarity and the reset_n pin with negative polarity. All the flip-flops shown are clocked on the rising edge of xtal_in and are fully scannable.

The reset signal to the core (init_n) is delayed by a purely combinatorial delay matched to the clock tree delay, so that the clock controller is reset and the clocks stopped before the init_n signal is received by the core. The FSM 54 always reads the init_n signal after the delay (re-synchronising it to the xtal clock before doing so) to ensure that the init_n signal has been deasserted before restarting clocks.

The wdog1 and wdog0 signals are always zero when the init_n signal is released, since the flip-flops issuing these signals will themselves be reset by the init_n signal. Test control multiplexing removes all sequential elements from the reset path during test mode, with only clock or reset being active at any one time.

The wdog0/1 signals are assumed to remain set until they are cleared by the reset they trigger, such that the retiming flip-flops ensure the watchdog reset 'pulse' is asserted for at least three cycles of the xtal_in clock.

A test_bus_off signal is sourced from the JTAG/TCB rather than the clock controller and simply follows the init_n signal when the TCB does not require use of the signal for its own purposes.

A reset status register is provided for reporting the last cause of a circuit reset. A circuit as shown in Figure 11 is sufficient to realise this. In the circuit shown in Figure 11 the wdog 1'/0' signals are the retimed versions from Figure 10 so are synchronised to xtal. Both flip-flops are clocked by xtal and are fully scannable. When the reset_n pad is asserted both flip-flops are reset low. If either (or both) watchdogs fire, then the flip-flops capture the value of the appropriate watchdog line. When reading the register, the bits will both contain '0' if a hard reset was applied last (that is, if reset_n was asserted) otherwise the bits will contain a '1' if the corresponding watchdog fired.

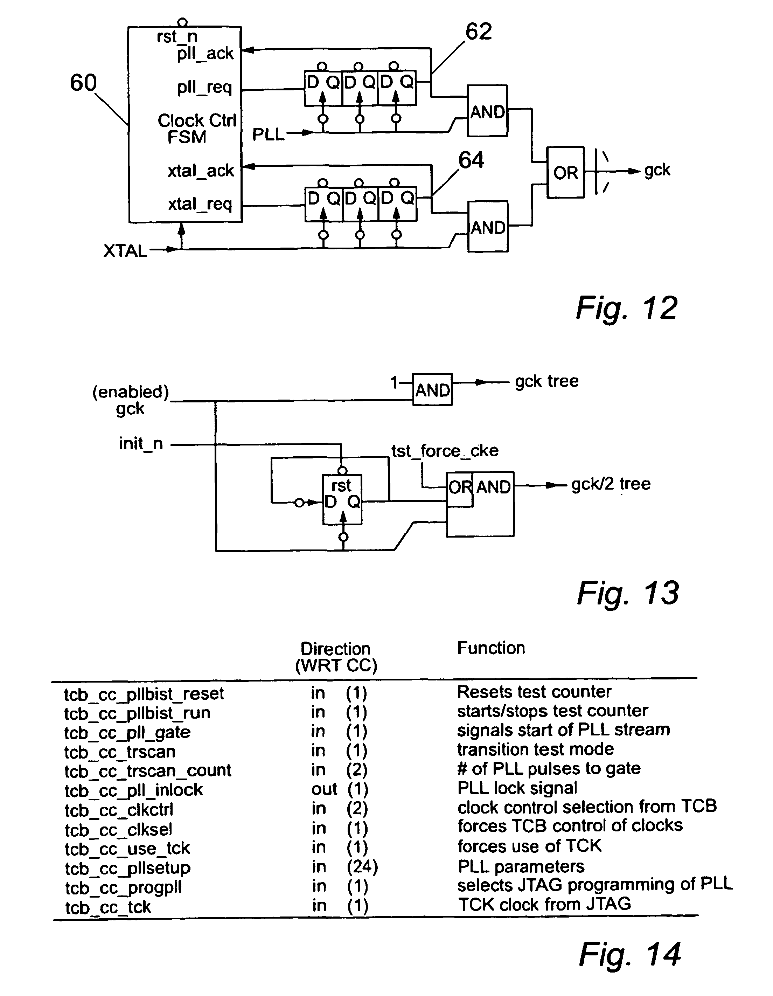

An example of a clock switching circuit is shown in Figure 12. Clock switching between xtal and the PLL 50 is controlled using a small FSM 60 and two banks of retiming flip-flops 62, 64.

The clock controller FSM 54 and the two sets of retiming flip-flops 62, 64 are reset asynchronously by the external reset source so that all clocks to the core are stopped. (The common reset line is not shown in Figure 12.)

The retiming flip-flops 62, 64 ensure that all changes to clock enabling occur while the relevant clock is low, ensuring that no 'runt' pulses are gated through to the clock tree. Three flip-flops are chosen for retiming to the PLL clock domain to minimise the likelihood of meta-stability problems. The retiming for the xtal domain could be accomplished with a single flip-flop if necessary, although it is envisaged that the same retiming structure as for the PLL 50 would be used in practice. The delay introduced by additional retiming flip-flops is not important.

On coming out of reset the FSM 60 selects xtal as the source of gck by default. During this selection, and at any other time when the FSM is asked to change the clock source, the FSM operates as follows. First it disables all clocks and waits until both pll_ack and xtal_ack are both zero to confirm this. Next it asserts one of the request bits as appropriate. Finally it waits for the corresponding acknowledge bit to go high.

While the FSM 60 is executing these steps it ignores all other requests for clock switching.

The Santorini clock controller requires a clock half the rate of the gck clock to be used for the main TDM bus and peripherals. This clock is derived in the clock controller by gating through every other gck pulse. Both gck and the gck/2 clocks are distributed over the whole circuit by identical clock tree structures. Figure 13 shows a suitable circuit for generating the gck and gck/2 clock pulses. In this circuit, the tst_force_cke signal ensures that the gck/2 clock is always driven directly in test mode.

During several of the test modes available, the internal clocks are controlled directly. In some of these modes the test mode controller itself may contain 'random' state, so the TCB always overrides any state in the clock controller.

In scan test modes the JTAG will usually force TCK to be the global clock. There is no requirement to stop the previous clock cleanly in this case. The circuit is always reset following a scan test.

In BIST modes the JTAG will select either TCK or PLL to be the global clock. Again, there is no clean start/stop requirement, since the circuit will always be reset following BIST operation.

In a COREDUMP mode the JTAG causes the original clock source to stop cleanly before switching to TCK (so that there is useful state to dump) but there is no requirement to resume operation.

In a complex TRSCAN mode the JTAG gates through a clean train of pulses from the PLL during capture cycles but uses TCK during the shift cycles.

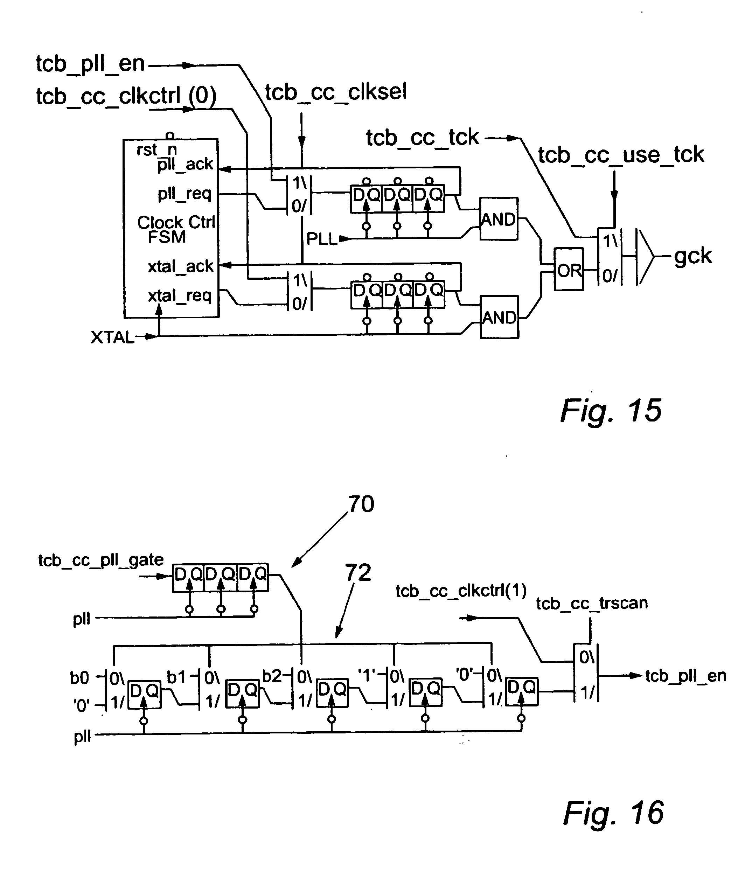

The TCB clock controller interface is made of the signals shown in Figure 14, shown applied in Figure 15 (that is, to the circuit of Figure 12). During normal operation the JTAG/TCB is in an idle state, so that the tcb_cc_use_tck and tcb_cc_clksel signals are both low. In this case the circuit operates exactly as described above.

During most of the scan tests, the TCB asserts the tcb_cc_use_tck signal and supplies the test clock (tcb_cc_tck) through to gck making scan operation entirely independent of the clock controller. This allows most of the clock controller itself to be scan-tested.

For the test modes which require the use of the PLL throughout (PLLBIST, RUNSIST), the tcb_cc_clksel signal is asserted and the tcb_pll_en line is driven high by the TCB.

Two test modes require use of both PLL and TCK:

- COREDUMP must cleanly stop both xtal_in and PLL sourced clocks to the core before switching over to TCK for shifting out state; and
- TRSCAN must use the PLL to fire short bursts of pulses in capture cycles while using the TCK clock for shifting out state.

When the COREDUMP instruction is loaded into the JTAG, the internal clocks are stopped by the JTAG asserting the tcb_cc_clksel signal and both tch_cc_clkctrl[0] and tcb_pll_en being held low. The JTAG pauses long enough for the clocks to be stopped through the retiming flip-flops 62, 64, before asserting the tcb_cc_use_tck signal and supplying the new TCK clock for shifting out the scannable state.

Operation of the transition fault test mode is as described above with reference to the timing diagram of Figure 6. In general the tcb_cc_use_tck signal will be high while the tst_scan_en signal (scan_en in Figure 6) is asserted, causing TCK to be used for shifting scan chains. However, for the capture cycles we need to gate through a variable number of pulses from the PLL. This pulse stream is timed from the signal tcb_cc_pll_gate (pulse_gate in Figure 6). The sequence of Figure 6 assumes that a stream of just two PLL pulses has been chosen for application to the core. In fact, it is possible to choose between 1 and 4 pulses as required.

When scan_en is pulled low (to go from shift to capture cycle) the signal should be allowed to stabilise over the whole circuit before allowing any pulses through. Hence tcb_cc_pll_gate (pulse_gate) is kept low until this has been achieved. When tcb_cc_pll_gate (pulse_gate) goes high, the clock controller lets out the programmed number of pulses. After some arbitrary period which is long enough for the multiple capture pulses to have been applied, the shift mode is re-entered by pulling tst_scan_en (scan_en) high. Tcb_cc_pll_gate can either be left high or driven low at this point.

Its state does not matter because no more PLL pulses will be driven, that is only the rising edge of tcb_cc_pll_gate is significant. However at some point during the shift the tcb_cc_pll_gate line must go low to reset the pulse counter in the clock controller. For simplicity this can be driven low throughout the shift period as shown in Figure 6.

Throughout TRSCAN operation the PLL is in the state programmed by the preceding PLLCTRL instruction.

A schematic diagram of the pulse stream gate is shown in Figure 16. The output signal tcb_pll_en drives the input signal of the same name in Figure 15. When the JTAG has a test instruction loaded other than one of the transition fault ones, the signal tcb_pll_en is taken directly from tcb_cc_clkctrl[1]. This is the case when running the PLLBIST or the RUNBIST instruction and so on. Of course, if the JTAG has no test instruction loaded then the value on the tcb_pll_en signal is in any case a don't care.

When the JTAG is loaded with a transition fault instruction the value of tcb_pll_en is taken from a shift register operating on the falling edge of the PLL clock. The shift register operates as follows. When tcb_cc_pll_gate is low the 4 LHS flip-flops 72 are preloaded with values 0011, 0111, or 1111 depending on which TRSCAN instruction is loaded, (the 4th flip-flop is always set to '1') and the 5th always to zero. Thus, it is possible to deliver 1,2,3 or 4 capture clocks cleanly. When tcb_cc_pll_gate goes high, this is retimed onto the rising edge of the PLL clock by three retiming flip-flops 70. Subsequently, this causes the lower flip-flops 72 to be configured into a shift register. The tcb_pll_en signal is further pipelined by the retiming flip-flops shown in earlier Figures but the additional delay is not important.

As the preloaded value is shifted out of the register, zeros are shifted in so that at the end of the capture sequence the PLL stream is always disabled irrespective of the state of the tcb_cc_pll_gate signal; the shift register has been flushed. The JTAG simply 'waits' for sufficient time for the capture to be completed before reselecting the TCK clock to shift out the captured data. (The selection is made asynchronously while the TCK clock is low to ensure that this is also clean.)

During the shift process, the tst_cc_pll_gate signal is raised again to prime the shift register ready for the next capture sequence.

None of the flip-flops 70, 72 can he scannable of course.

In the preferred embodiment, a test counter is provided in the PLL 50 as a simple digital test method for the PLL in production. Operation is controlled via the JTAG port using the PLLCTRL (set-up of PLL parameters) and PLLBIST (reset, start and stop of the test counter) instructions. The general scheme is to set up the PLL so that it is running at a specific frequency and then to reset the test counter, count pulses for a given period of time and then to stop the counter and inspect the value, comparing it against a guardbanded figure to account for tester timing inaccuracies and so on.

The test counter itself can be implemented as a simple 20 bit ripple counter and is not included in the scan test of the clock control block. The counter is considered to be fully tested by implication during the PLL test.

It will be apparent in this example that the functions of the clock controller have been divided up between the Santorini clock control block and the JTAG/TCB. This simplifies the design of the clock control block and, by leaving the test port to force control of clocks during the various test modes, allows most of the clock control block itself to be scan tested. The only non-scan testable parts are the PLL test counter (tested as a part of the PLLBIST test) and a small number of key retiming flip-flops.

**Claims**

1. A method of scan testing a logic circuit (12) which is driven by internal oscillating means (16) capable to produce a high frequency clock and an external clock (14), which external clock (14) during normal operation is used to time control the operation of the logic circuit (12); the method including the steps of disabling the external clock (14), synchronizing testing means with the internal oscillating means (16), performing scan testing on the logic circuit (12) while the external clock (14) is disabled and re-enabling the external clock (14) following testing on the logic circuit (12),

   **characterized in that**

   the method further includes the step of enabling scan chain shifting, the method providing the external clock (14) during such scan chain shifting,

   whereby the test clock controller externally controls three control inputs (use_tck, pulse_gate, num_pulses) of a clock switch (10) interposed in a clock line between the logic circuit (12) and the externally supplied test clock (14) and the free-running internal oscillating means (16),

   whereby a signal (scan_en) is generally held high so as to perform scan shifing and is low for capture cycles, and when the signal (scan_en) is pulled low to go from shift to capture cycle, the signal (scan_en) is allowed to stabilize over the whole logic circuit (12) before allowing any pulses through by keeping the input (pulse_gate) low, and when the input (use_tck) is high, the clock switch (10) couples the test clock (14) to the logic circuit (12) to be tested, and when the input (pulse_gate) is set high, a pre-programmed number of pulses form the internal oscillating means (16) is coupled through to the logic circuit (12) under test in place of the test clock (14).

2. A method according to claim 1, wherein the internal oscillating means which is used is a phase locked loop (16) within the logic circuit (12).

3. A method according to claim 1 or 2, including the step of determining the length of time during which the external clock (14) is disabled.

4. A method according to any preceding claim, wherein for transition testing which includes a capture phase, the method includes the step of disabling propagation of the external clock (14) prior to the capture phase, emitting a predetermined number of high speed oscillator pulses and switching back to the external clock (14) to shift captured data off-chip.

5. A system for scan testing a logic circuit (12) which is driven by internal oscillating means (16) capable to produce a high frequency clock and an external clock (14), which external clock (14) during normal operation is used to time control the operation of the logic circuit (12); the system including a clock controller operable to disable the external clock (14); to synchronize testing means with the internal oscillating means (16), and to re-enable the external clock (14) following testing on the logic circuit (12)

   **characterized in that** the controller is operable to provide the external clock signal for scan chain shifting testing, and

   a clock switch (10) is provided which is interposed in the clock line between the logic circuit (12) and the externally supplied test clock (14) and the free-running internal oscillating means (16), the output of the clock switch (10) being a line (logic_clk), which is the clock signal actually seen by the internal logic circuit (12) under test, whereby the clock switch (10) includes three control inputs (use_tck, pulse_gate, num_pulses), whereby these signals are externally controlled by the test clock controller, whereby a signal (scan_en) is generally held high so as to perform scan shifting and is low for capture cycles, and when the signal (scan_en) is pulled low to go from shift to capture cycle, the signal (scan_en) is allowed to stabilize over the whole logic circuit (12) before allowing any pulses through by keeping the input (pulse_gate) low, and when the input (use_tck) is high, the clock switch (10) couples the test clock (14) to the logic circuit (12) to be tested, and when the input (pulse_gate) is set high, a pre-programmed number of pulses form the internal oscillating means (16) is coupled through to the logic circuit (12) under test in place of the test clock (14).

6. A system according to claim 5, wherein the internal oscillating means is a phase locked loop (16).

7. A system according to claim 5 or 6, wherein the test clock controller includes means for setting the length of time during which the external clock (14) is disabled.

8. A system according to any of claims 5 to 7, wherein the test clock controller is a Santorini clock controller.


**Patentansprüche**

1. Verfahren zum Scan-Testen einer Logikschaltung (12), die von internen Schwingeinrichtungen (16) angetrieben wird, die einen Hochfrequenz-Takt und einen externen Takt (14) erzeugen können, wobei der externe Takt (14) während des Normalbetriebs verwendet wird, um den Betrieb der Logikschaltung zeitlich zu steuern, wobei das Verfahren die Schritte des Deaktivierens des externen Takts (14), des Synchronisierens von Testeinrichtungen mit der internen Schwingeinrichtung (16), des Durchführens von Scan-Tests der Logikschaltung (12), während der externe Takt (14) deaktiviert ist, und das Wiederaktivieren des externen Takts (15) nach dem Testen der Logikschaltung (12) aufweist,
   **dadurch gekennzeichnet, dass**
   das Verfahren des Weiteren den Schritt des Aktivierens des Scan Chain Shifting umfasst, wobei das Verfahren den externen Takt (14) während des Scan Chain Shiftings bereitstellt, wobei die Testtaktsteuerung drei Steuereingänge (use_tck, pulse_gate, num_pulses) eines Taktschalters (10), der in einer Taktleitung zwischen der Logikschaltung (12) und dem extern zugeführten Testtakt (14) und der freilaufenden internen Schwingeinrichtung (16) zwischengeschaltet ist, extern steuert,
   wobei ein Signal (scan_en) im allgemeinen hoch gehalten wird, um Scan Shifting durchzuführen, und für Capture Zyklen niedrig ist, und wenn das Signal (scan_en) heruntergezogen wird, um vom Shift in den Capture Zyklus zu gehen, sich das Signal (scan_en) über die gesamte Logikschaltung (12) stabilisieren kann, bevor Impulse durchgelassen werden, indem der Eingang (pulse_gate) niedrig gehalten wird, und wenn der Eingang (use_tck) hoch ist, der Taktschalter (10) den Testtakt (14) an die zu testende Logikschaltung (12) koppelt, und wenn der Eingang (pulse_gate) hoch gesetzt wird, eine vorprogrammierte Anzahl von Impulsen von der internen Schwingeinrichtung (16) anstelle des Testtakts (14) zu der Logikschaltung (12), die getestet wird, durchgekoppelt wird.

2. Verfahren nach Anspruch 1, wobei die verwendete interne Schwingeinrichtung ein Phase Locked Loop (16) innerhalb der Logikschaltung (12) ist.

3. Verfahren nach Anspruch 1 oder 2, das den Schritt des Ermittelns der Zeitdauer umfasst, während der der externe Takt (14) deaktiviert ist.

4. Verfahren nach einem der vorhergehenden Ansprüche, wobei zum Übergangstesten, das eine Capture-Phase umfasst, das Verfahren den Schritt des Deaktivierens der Fortpflanzung des externen Takts (14) vor der Capture-Phase aufweist, des Aussendens einer vorgegebenen Anzahl von Hochgeschwindigkeits-Oszillatorimpulsen, und des Zurückschaltens auf den externen Takt (14), um erfasste Daten vom Chip herunter zu schieben.

5. System zum Scan-Testen einer Logikschaltung (12), die von internen Schwingeinrichtungen (16) angetrieben wird, die einen Hochfrequenz-Takt und einen externen Takt (14) erzeugen können, wobei der externe Takt (14) während des Normalbetriebs verwendet wird, um den Betrieb der Logikschaltung (12) zeitlich zu steuern, wobei das System eine Taktsteuerung aufweist, die so betrieben werden kann, dass sie den externen Takt (14) deaktiviert, Testeinrichtungen mit der internen Schwingeinrichtung (16) synchronisiert, und den externen Takt (14) nach dem Testen der Logikschaltung (12) wieder aktiviert,
   **dadurch gekennzeichnet, dass**
   die Steuerung so betrieben werden kann, dass sie das externe Taktsignal zum Scan Chain Shift Testen bereitstellt, und dass

ein Taktschalter (10) bereitgestellt wird, der in der Taktleitung zwischen der Logikschaltung (12) und dem extern zugeführten Testtakt (14) und der freilaufenden internen Schwingeinrichtung (16) zwischengeschaltet ist, wobei der Ausgang des Taktschalters (10) eine Leitung (logic_clk) ist, die das Taktsignal, das tatsächlich von der internen getesteten Logikschaltung (12) gesehen wird, ist, wobei die Taktschaltung (10) drei Steuereingänge (use_tck, pulse_gate, num_pulses) aufweist, wobei diese Signale extern durch die Testtaktsteuerung gesteuert werden, wobei ein Signal (scan_en) im allgemeinen hoch gehalten wird, um Scan Shifting durchzuführen, und für Capture Zyklen niedrig ist, und wenn das Signal (scan_en) heruntergezogen wird, um von Shift in den Capture Zyklus zu gehen, kann sich das Signal (scan_en) über die gesamte Logikschaltung (12) stabilisieren, bevor Impulse durchgelassen werden, indem der Eingang (pulse_gate) niedrig gehalten wird, und wenn der Eingang (use_tck) hoch ist, koppelt der Taktschalter (10) den Testtakt (14) an die zu testende Logikschaltung (12), und wenn der Eingang (pulse_gate) hoch gesetzt wird, wird eine vorprogrammierte Anzahl von Impulsen von der internen Schwingeinrichtung (16) anstelle des Testtakts (14) zu der Logikschaltung (12), die getestet wird, durchgekoppelt.

**6.** System nach Anspruch 5, wobei die interne Schwingeinrichtung ein Phase Locked Loop (16) ist.

**7.** System nach Anspruch 5 oder 6, wobei die Testtaktsteuerung Einrichtungen zum Einstellen der Zeitdauer, während der der externe Takt (14) deaktiviert ist, aufweist.

**8.** System nach einem der Ansprüche 5 bis 7, wobei die Testtaktsteuerung eine Santorini Taktsteuerung ist.

## Revendications

**1.** Procédé consistant à tester par analyse un circuit logique (12) qui est piloté par des moyens d'oscillation internes (16) capables de produire une horloge à haute fréquence et une horloge externe (14), laquelle horloge externe (14) en fonctionnement normal est utilisée pour contrôler temporellement le fonctionnement du circuit logique (12) ; le procédé comprenant les étapes consistant à désactiver l'horloge externe (14), à synchroniser les moyens de test avec les moyens d'oscillation internes (16), à exécuter le test d'analyse sur le circuit logique (12) pendant que l'horloge externe (14) est désactivée, et à réactiver l'horloge externe (14) après le test sur le circuit logique (12), **caractérisé en ce que**

le procédé comprend en outre l'étape consistant à permettre le décalage de la chaîne d'analyse, le procédé proposant l'horloge externe (14) pendant un tel décalage de la chaîne d'analyse,

moyennant quoi le contrôleur d'horloge de test contrôle extérieurement trois entrées de commande (use_tck, pulse_gate, num_pulses) d'un commutateur d'horloge (10) interposé dans une ligne d'horloge entre le circuit logique (12) et l'horloge de test alimentée de l'extérieur (14) et les moyens d'oscillation interne libre (16),

moyennant quoi un signal (scan_en) est généralement maintenu à l'état haut afin d'exécuter le décalage d'analyse et est à l'état bas pour les cycles de capture, et quand le signal (scan_en) est tiré à l'état bas pour passer du décalage au cycle capture, on laisse le signal (scan_en) se stabiliser sur le circuit logique entier (12) avant de laisser passer toute impulsion en maintenant l'entrée (pulse_gate) à l'état bas, et quand l'entrée (use_tck) est à l'état haut, le commutateur d'horloge (10) couple l'horloge de test (14) au circuit logique (12) à tester, et quand l'entrée (pulse_gate) est définie à l'état haut, pendant un nombre préprogrammé d'impulsions, les moyens d'oscillation internes (16) sont couplés au circuit logique (12) sous test au lieu de l'horloge de test (14).

**2.** Procédé selon la revendication 1, dans lequel les moyens d'oscillation internes qui sont utilisés sont une boucle à verrouillage de phase (16) à l'intérieur du circuit logique (12).

**3.** Procédé selon la revendication 1 ou 2, comprenant l'étape consistant à déterminer la durée pendant laquelle l'horloge externe (14) est désactivée.

**4.** Procédé selon l'une quelconque des revendications précédentes, dans lequel pour le test de transition qui comprend une phase de capture, le procédé comprend l'étape consistant à désactiver la propagation de l'horloge externe (14) avant la phase de capture, à émettre un nombre prédéterminé d'impulsions d'oscillateur à grande vitesse et à rebasculer à l'horloge externe (14) pour décaler les données capturées hors circuit intégré.

**5.** Système pour tester par analyse un circuit logique (12) qui est piloté par des moyens d'oscillation internes (16) capables de produire une horloge à haute fréquence et une horloge externe (14), laquelle horloge externe (14) en fonctionnement normal est utilisée pour contrôler réellement le fonctionnement du circuit logique (12) ; le système comprenant un contrôleur d'horloge utilisable pour désactiver l'horloge externe (14) ; pour synchroniser les moyens de test avec les moyens d'oscillation internes (16), et pour réactiver l'horloge externe (14) après le test sur le circuit logique (12) **caractérisé en ce que** le contrôleur est utilisable pour proposer le signal d'horloge externe pour tester par analyse avec décalage de chaîne, et

un commutateur d'horloge (10) est proposé qui est interposé dans la ligne d'horloge entre le circuit logique (12) et l'horloge de test alimentée de l'extérieur (14) et les moyens d'oscillation internes libres (16), la sortie du commutateur d'horloge (10) étant une ligne (logic_clk), qui est le signal d'horloge vu réellement par le circuit logique interne (12) sous test, moyennant quoi le commutateur d'horloge (10) comprend trois entrées de commande (use_tck, pulse_gate, num_pulses), moyennant quoi ces signaux sont contrôlés de l'extérieur par le contrôleur d'horloge de test, moyennant quoi un signal (scan_en) est généralement maintenu à l'état haut de manière à exécuter le décalage d'analyse et est à l'état bas pour les cycles de capture, et lorsque le signal (scan_en) est tiré à l'état bas pour passer de décalage au cycle de capture, on laisse le signal (scan_en) se stabiliser sur le circuit logique tout entier (12) avant de laisser passer de quelconques impulsions en maintenant l'entrée (pulse_gate) à l'état bas, et lorsque l'entrée (use_tck) est à l'état haut, le commutateur d'horloge (10) couple l'horloge de test (14) au circuit logique (12) à tester, et quand l'entrée (pulse_gate) est définie à l'état haut, pendant un nombre préprogrammé d'impulsions, les moyens d'oscillation internes (16) sont couplés au circuit logique (12) sous test au lieu de l'horloge de test (14).

6. Système selon la revendication 5, dans lequel les moyens d'oscillation internes sont une boucle à verrouillage de phase (16).

7. Système selon la revendication 5 ou 6, dans lequel le contrôleur d'horloge de test comprend des moyens pour définir la durée pendant laquelle l'horloge externe (14) est désactivée.

8. Système selon l'une quelconque des revendications 5 à 7, dans lequel le contrôleur d'horloge de test est un contrôleur d'horloge de Santorini.

Fig. 1

Fig. 2

*Fig. 3*

*Fig. 4*

*Fig. 5*

*Fig. 6*

Fig. 7

Fig. 8a

This is programmed as 0x50021C12

- enable = 1
- PDIV = 0x1 = 1
- MDIV = 0x1C = 28
- NDIV = 0x02 = 2
- SETUP = 0x50 (example value only)

Fig. 8b

| 31-4 | 3 | 2 | 1 | 0 |
|------|------|------|-----------|------------|
| X | wdog1 | wdog0 | clkSource | PLLnotXtal |
| R | R | R | R | R/W |

*Fig. 9*

*Fig. 10*

*Fig. 11*

60

rst_n
pll_ack
pll_req
Clock Ctrl
FSM
PLL
xtal_ack
xtal_req
XTAL

62

D Q | D Q | D Q
AND
OR → gck

64

D Q | D Q | D Q
AND

**Fig. 12**

(enabled)
gck                                                    1—AND → gck tree

init_n

tst_force_cke

rst
D Q                    OR AND → gck/2 tree

**Fig. 13**

|  | Direction (WRT CC) | | Function |
|---|---|---|---|
| tcb_cc_pllbist_reset | in | (1) | Resets test counter |
| tcb_cc_pllbist_run | in | (1) | starts/stops test counter |
| tcb_cc_pll_gate | in | (1) | signals start of PLL stream |
| tcb_cc_trscan | in | (1) | transition test mode |
| tcb_cc_trscan_count | in | (2) | # of PLL pulses to gate |
| tcb_cc_pll_inlock | out | (1) | PLL lock signal |
| tcb_cc_clkctrl | in | (2) | clock control selection from TCB |
| tcb_cc_clksel | in | (1) | forces TCB control of clocks |
| tcb_cc_use_tck | in | (1) | forces use of TCK |
| tcb_cc_pllsetup | in | (24) | PLL parameters |
| tcb_cc_progpll | in | (1) | selects JTAG programming of PLL |
| tcb_cc_tck | in | (1) | TCK clock from JTAG |

**Fig. 14**

*Fig. 15*

*Fig. 16*